# FASCICULE DE BREVET EUROPEEN

(11) **EP 0 389 306 B1**
(45) Date de publication et mention de la délivrance du brevet: **08.06.1994**
(21) Numéro de dépôt: 90400136.9
(22) Date de dépôt: 18.01.1990
(51) Int. Cl.: G01R 31/302, G01R 31/308

(54) **Procédé pour le contrôle d'une carte de circuit imprimé équipée, notamment le contrôle des soudures de la carte et appareillage pour la mise en oeuvre de ce procédé**
Verfahren zur Prüfung einer bestückten Karte mit gedruckter Schaltung, speziell zur Prüfung der Lötstellen der Karte und Gerät zur Durchführung dieses Verfahrens
Procedure and inspecting an equipped printed circuit board, especially for inspecting the bonds on the board and apparatus for performing this procedure

(30) Priorité: 19.01.1989 FR 8900612
(43) Date de publication de la demande: 26.09.1990
(73) Titulaire: BULL S.A., 92800 Puteaux (FR)
(72) Inventeur: Quintard, Alain, F-91620 La Ville Du Bois (FR)
(74) Mandataire: Colombe, Michel

(56) Documents cités:
- US-A- 3 868 508
- US-A- 4 792 683
- ELECTRONIC DESIGN, vol. 28, no. 3, 1 février 1980, page 19, Rochelle Park, US;"Infrared imaging pins down PC-board solder-joint faults"
- 28TH ELECTRONIC COMPONENTS CONFERENCE, Anaheim, CA, 24-26 avril 1978, pages286-289, IEEE, New York, US; J.M. KONKLIN et al.: "The infrared signature forPC boards maintenance"
- PROCEEDINGS OF THE INTERNATIONAL TEST CONFERENCE, 19-21 novembre 1985, pages413-418, IEEE, New York, US; H. BOULTON: "New concepts of applyingthermographic testing to printed circuit boards and finished products"
- ELECTRONICS TEST, vol. 11, no. 6, juin 1988, pages 89-90,92, San Francisco, US;K. POMEROY: "Pinpointing shorts with color thermography"

## Description

### PROCEDE POUR LE CONTROLE D'UNE CARTE DE CIRCUIT IMPRIME EQUIPEE, NOTAMMENT LE CONTROLE DES SOUDURES DE LA CARTE, ET APPAREILLAGE POUR LA MISE EN OEUVRE DE CE PROCEDE.

La présente invention concerne un procédé pour le contrôle d'une carte de circuit imprimé équipée, notamment le contrôle des soudures de la carte. Par carte de circuit imprimé équipée on entend une carte de circuit imprimé dont l'architecture est bâtie autour d'une couche de matière isolante telle que la résine époxy et comportant un certain nombre de composants électroniques. Parmi ces composants électroniques il faut distinguer deux catégories, les composants passifs tels que les résistances et les condensateurs et les composants actifs tels que les diodes, les transistors et les circuits intégrés.

Ces composants sont soudés par utilisation de procédés classiques tel le soudage à la vague ou le soudage par refusion notamment la variante dite en phase vapeur, les matériaux de soudure couramment utilisés étant à base d'alliage étain-plomb. Au sortir de l'opération de soudage, il importe préalablement à tout test fonctionnel sous tension de la carte de circuit imprimé, de contrôler l'intégrité de la carte et tout particulièrement le bon état mécanique et électrique des soudures. En effet on considère aujourd'hui que la majorité des défauts (hors composants) d'une carte de circuit imprimé équipée vient des soudures. Plus rarement on relève des défauts dus à l'absence, au mauvais positionnement ou du mauvais fonctionnement de certains composants. Pour faire ce premier contrôle, on utilise généralement à ce jour un appareil dit "planche à clous" muni d'un grand nombre de pointes qui viennent en contact avec certains points du circuit à contrôler. Ces appareils qui donnent de bons résultats, sont cependant relativement délicats à fabriquer et à mettre en oeuvre car ils doivent être adaptés à chaque modèle de carte à contrôler.

De plus, ces appareils ne permettent pas le contrôle ponctuel de la soudure, mais seulement la vérification du bon état de conduction électrique entre plusieurs points du circuit par rapport au dessin de ce dernier. (En fait, seul l'examen visuel par binoculaire, avec ses contraintes et ses limites, permet ce contrôle direct d'un point de soudure).

Par ailleurs l'introduction de la novuelle technologie dite des composants à montage en surface (CMS) a permis une miniaturisation des circuits imprimés et de leurs composants, miniaturisation qui pose de réels problèmes pour le contrôle des cartes CMS par des appareils type "planche à clous". En effet, la dimension minimum des supports de pointe interdit à celles-ci l'accès de zones de la carte trop rapprochées. A titre d'exemple le pas moyen utilisé dans les cartes CMS est de 1,27 mm au lieu de 2,54 mm pour les cartes classiques. Avec l'adoption du nouveau standard de 0,3 mm pour les cartes CMS, les appareils de contrôle type "planche à clous" seront complètement inadaptés voire inutilisables.

Des tentatives ont été faites pour contrôler des soudures par radiographie aux rayons X. Si ce procédé donne théoriquement de bons résultats, il présente néanmoins un certain nombre d'inconvénients dans la pratique qui sont son prix et sa difficulté de mise en oeuvre.

Par l'article publié dans "Electronic Design" Volume 28, N° 3 du 01 février 1980 page 19 intitulé "Infrared imaging pins down PC-board solder-joint faults", on connaît l'utilisation de la thermographie laser pour le contrôle unitaire de soudures effectué point par point de façon discontinue à l'issue de chaque opération élémentaire de réalisation du point de soudure. Il en résulte que ce procédé n'est pas adapté pour le contrôle en fin de fabrication de soudures de cartes de circuit imprimé complètement équipées.

Il est également connu par le document US 3 868 508 d'alimenter une plaque de circuit et d'observer avec une caméra les radiations infrarouges émises par la plaque de circuit. Toutefois ce dispositif nécessite la présence d'une ventilation pour éviter que les radiations infrarouges émises par la plaque de circuit soit déformée par l'échauffement de la masse d'air adjacente aux composants du circuit. En outre, ce dispositif nécessite de soumettre tout d'abord un circuit de référence aux tensions d'alimentation normales et aux signaux d'entrée sélectionnés pour prendre une image infrarouge de ce circuit. Cette image servira de référence pour les circuits à attester.

Enfin il est également connu par le brevet US 4 792 683 d'éclairer toute la plaque de circuit imprimé par des impulsions répétitives de chauffage et d'effectuer la mesure de l'émission infrarouge entre les impulsions de chauffage avec le test de tous les joints simultanément. Un tel procédé à l'inconvénient de manquer de précision dans le cas de cartes complexes.

Les qualités demandées à un procédé de contrôle de carte de circuit imprimé équipée, notamment de contrôle de soudure selon l'invention sont :
- Le procédé doit être du type non destructif ; sa mise en oeuvre ne doit pas risquer de détériorer la carte et ses composants.
- Le procédé doit permettre son automatisation, pour des raisons de cadence, mais aussi pour éliminer toute appréciation humaine variable selon les opérateurs.
- Le procédé doit permettre la localisation immédiate des points défectueux sur la carte afin de pouvoir procéder à des interventions de dépannage ponctuel.
- Enfin, le procédé de contrôle doit, pour être performant, être de mise en oeuvre facile, adaptable aux divers modèles de carte, rapide et relativement peu onéreux.

A cette fin l'invention propose un procédé pour le contrôle d'une carte de circuit imprimé équipée, comportant au moins les phases suivantes :
- chauffage continu et de courte durée de la carte jusqu'à ce qu'une température de consigne appropriée pour obtenir des écarts de température significatifs à la surface de la carte soit mesurée en un point cible sur la carte ;
- définition d'une fenêtre de validation des mesures effectuées après que le chauffage ait cessé ;
- prise d'une image thermographique de la carte pendant cette fenêtre de validation des mesures, l'image thermographique consistant en des mesures de température instantanées, en fonction de la position de la carte à un instant donné pendant la fenêtre de validation des mesures ;
- et traitement de l'image par détection d'écart thermique par rapport à une image thermographique standard prédéfinie et à l'image thermographique de la carte.

Par l'utilisation d'un chauffage de courte durée, le procédé selon l'invention permet d'apprécier la quantité, la qualité (fissures, bavures, etc...) de l'apport de soudure (et également son absence) aux diverse aires d'accueil à contrôler. De même, du fait de la propre masse de chaque composant, il est possible de détecter leur absence ou leur mauvais positionnement.

Selon une autre particularité de l'étape de traitement, l'écart thermique maximum considéré comme admissible pour le contrôle des soudures est choisi en fonction de la température moyenne en surface de la carte à l'instant d'arrêt du chauffage.

Le procédé selon l'invention donne particulièrement de bons résultats lorsque le seuil d'écart thermique admissible est fixé à 3°C pour une température moyenne de chauffage de l'ordre de 70°C.

Dans une autre variante du procédé selon l'invention, l'arrêt du chauffage est commandé lorsque la température de surface d'un point cible de la carte atteint une valeur de consigne, par exemple 70°C. En choisissant pour point cible une zone fiable de la carte peu sujette à des dérives thermiques d'une carte à une autre, on obtient ainsi une référence quasi parfaite.

Toujours à titre de variante, le chauffage de la carte est régulé en fonction d'une courbe de montée en température prédéfinie, avec réduction progressive de la puissance de chauffage aux abords de la température de consigne.

On évite ainsi les zones de chauffage turbulent qui pourraient introduire des écarts thermiques importants sur la carte et indésirables pour le contrôle de soudures. De préférence on choisit un chauffage de carte par un pyropanel à lampes de quartz.

Selon une autre variante de l'invention, la prise d'image est effectuée en temps réel par une caméra infrarouge (36), travaillant dans un domaine spectral compris entre 8 et 12 microns après le déplacement de la carte hors de la zone de chauffage dès l'arrêt du chauffage.

Selon une autre particularité, la prise d'image n'est autorisée que pendant une période de validation Vmax commençant à l'instant d'arrêt de la phase de chauffage et dont la durée est dépendante de l'écart thermique maximum acceptable, une période de validation ayant une durée de 100 secondes pour une température de chauffage moyenne de 70°C et un écart thermique maximum de 3°C.

Selon une autre variante du procédé de l'invention, une image étalon est définie pour chaque modèle de carte avec un repérage géographique à deux dimensions de la localisation vraie de points sélectionnés du circuit imprimé et des composants équipant ledit circuit imprimé. Avantageusement le repérage géographique est associé à un découpage virtuel de la carte en zones d'exploration unitaires correspondant chacune au champ spatial de la caméra infra-rouge. De plus le repérage géographique réalise la localisation vraie à l'intérieur de chaque zone d'exploration des diverses régions à contrôler, notamment des aires d'accueil de soudures. Pour finir, il est prévu que la localisation vraie de l'aire d'accueil pour laquelle la soudure est reconnue défectueuse (comme celle de toute autre région reconnue défectueuse) soit affichée à l'issue du traitement de l'image.

Selon une autre particularité, l'opération de détection d'écart thermique n'est effectuée que sur les portions d'images correspondant à une grille géographique prédéfinie des régions à contrôler.

Selon une autre variante du procédé de l'invention, la prise de l'image complète de la carte (ou 'une portion étendue de celle-ci est obtenue par déplacement latéral du champ de la caméra par rapport à la carte, chaque positionnement caméra/carte correspondant au recouvrement par champ de la caméra d'une zone d'exploration unitaire.

Selon encore une autre variante du procédé de l'invention, l'étalon est crée par mixage d'une pluralité d'images obtenues à partir de cartes de référence de même modèle réputés admissibles, le dit étalon étant optionnellement paramétrable.

Selon une autre particularité, il est utilisé pour le contrôle des soudures de cartes de circuit imprimé équipées de composants à montage en surface (CMS).

L'invention concerne également un appareillage pour la mise en oeuvre du procédé défini ci-dessus, l'appareillage comportant :
- un support de carte ;
- une chaîne de chauffage ;
- une chaîne de prise d'image, comportant une caméra infrarouge et un convertisseur générant par relevé d'image unitaire un bloc d'informations ;
- une chaîne de traitement d'image comportant des moyens de stockage du bloc d'informations correspondant au relevé d'image unitaire ;
- des moyens de stockage d'une image étalon constituée d'un ensemble de signaux étalons, chaque signal étalon étant apparié avec la localisation vraie d'un point objet quelconque de la carte ;
- des moyens de comparaison, pour une même localisation vraie, d'un signal de mesure avec le signal étalon ;
   et des moyens d'affichage de la localisation vraie concernée et du résultat de l'opération de comparaison ;
- le support de carte étant muni d'un agencement permettant le repérage géographique à deux dimensions de ladite localisation vraie,
- le bloc d'informations de la chaîne de prise d'image comportant pour chaque point image du champ image de la caméra la localisation image correspondante et le signal de mesure représentatif de la température au point objet associé de la carte couvert par le champ élémentaire objet de la caméra,
- un dispositif de pointage du champ de la caméra est associé audit support de carte, ledit agencement de repérage géographique étant adapté pour effectuer le repérage du positionnement du champ de la caméra par rapport à la carte,
- la chaîne de traitement d'image comportant également :
   . des moyens associés audit agencement de repérage géographique, pour déterminer la localisation vraie du point objet associé à une localisation image donnée du bloc d'information correspondant au relevé d'image unitaire donné et apparier chaque signal de mesure à la localisation vraie correspondante.

Selon une autre particularité, le dit support de carte comporte aussi un bâti fixe (22) portant ledit dispositif de pointage du champ de la caméra et muni de moyens de guidage (24) de la carte.

Selon une autre particularité, ledit agencement de repérage géographique est de type tridimensionnel (CX,CY,CZ,34) et comporte une station pilote (34) pour effectuer le repérage du positionnement du champ de la caméra et commander des moyens d'actionnement (MX,MY,MZ) desdits moyens de guidage (24) et dudit dispositif de pointage (38) pour permettre des déplacements relatifs entre la carte (26) et le champ de la caméra (36).

Selon une autre particularité, les moyens de guidage (24) de la carte comportent un jeu de rails de guidage (28,30,32) et un chariot porteur de carte (26) pour permettre le déplacement de la carte dans deux directions perpendiculaires (X,Z).

Selon une autre particularité, le dispositif de pointage (38) du champ de la caméra est susceptible de déplacement selon une direction normale (Y) au plan de déplacement (X,Z) dudit chariot.

Selon une autre particularité, la station pilote (34) commande les chaînes de prise et de traitement d'image (36,42) et gère un processus de relevé et de traitement d'images unitaires de façon séquentielle à partir d'un découpage virtuel de la carte en zones élémentaires d'exploration (ZEi) correspondant au champ objet de la caméra couvert par une image unitaire.

Selon une autre particularité, ladite station pilote (34) génère les ordres de relevé d'image unitaire en fonction d'un programme prédéfini d'exploration géographique de la carte.

Selon une autre particularité, ladite station pilote (34) transmet auxdits moyens pour apparier chaque signal de mesure à la localisation vraie correspondante, présents dans ladite chaîne de traitement d'image, des informations concernant le positionnement instantané du champ de la caméra par rapport à la carte utilisée lors de chaque relevé d'image unitaire.

Selon une autre particularité, la station pilote (34) commande un déplacement relatif entre la carte (26) et le champ de la caméra (36) après chaque relevé d'image unitaire.

Selon une autre particularité, la station pilote (34) débute ledit processus de prise et de traitement d'image à la réception d'un signal de début issu par la station de contrôle (54).

L'invention est maintenant décrite en référence aux figures ci-annexées dans lesquelles :
- La figure 1 représente un diagramme de courbes de température en fonction du temps pour des soudures de qualités différentes.
- La figure 2 est une représentation schématique d'une carte de circuit imprimée équipée illustrant le repérage géographique de points donnés de la carte.
- La figure 3 est une représentation schématique d'un appareillage de mise en oeuvre du procédé selon l'invention.
- La figure 4 est une représentation schématique d'un chronogramme illustrant le déroulement d'un contrôle de carte selon l'invention.

Dans le cadre du contrôle des soudures d'une carte de circuit imprimée équipée, une "mauvaise" soudure se caractérise en général de façon quantitative par un apport de matière insuffisant, ou son absence pure et simple, à l'aire d'accueil prédéfinie. De plus, une "mauvaise" soudure peut présenter des défauts d'ordre qualitatif au niveau de la répartition de l'apport de soudure (par exemple fissures, bavures, cheveux, etc...). Tous ces défauts (d'ordre quantitatif et qualitatif) peuvent entraîner à terme une rupture mécanique de la soudure et/ou des défauts au niveau des connexions électriques.

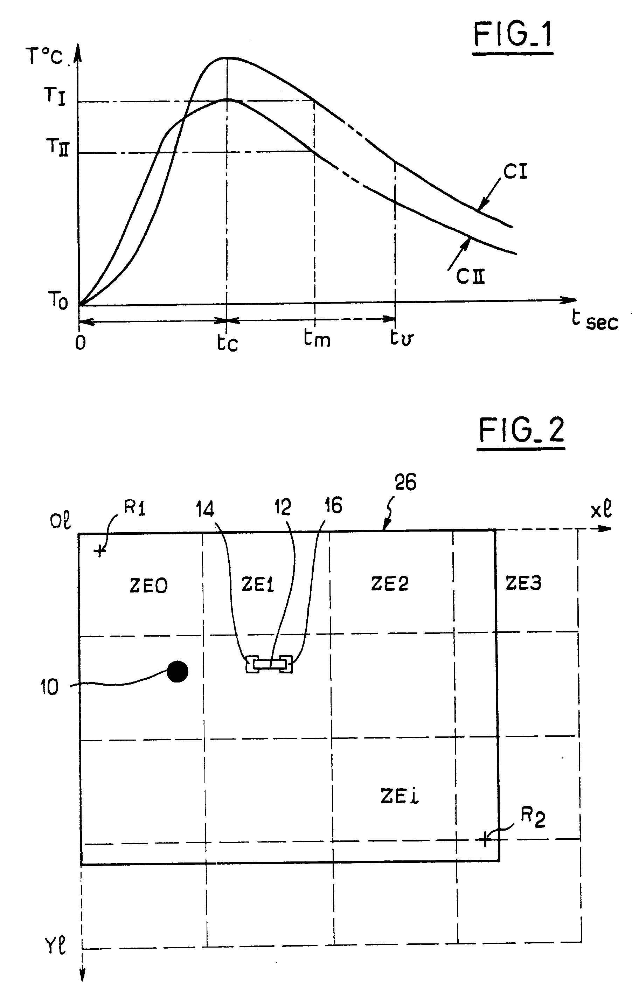

C'est cette variation de la masse de la matière d'apport ou de la répartition de cet apport dans l'aire d'accueil de soudure qui est mise en évidence dans le procédé du contrôle par thermographie selon l'invention. Le procédé est basé en partie sur l'observation qu'un chauffage rapide de courte durée, appelé parfois chauffage impulsionnel, de la carte à contrôler se traduit par des variations de la température de surface d'une aire d'accueil donnée selon la quantité et/ou la répartition du matériau de soudure apporté (le temps de chauffage est choisi trop court pour permettre un équilibre de température dans tout le volume de la carte). D'une façon générale, à la fin de la période de chauffage, la température en surface d'une soudure de faible apport sera moindre que celle d'une soudure suffisamment garnie. De même, l'énergie calorifique emmagasinée par la soudure, proportionnelle à la masse de matière présente, sera réduite. Ce phénomène est illustré à la figure 1 qui présente deux courbes schématiques d'évolution de la température en fonction du temps pendant les phases de chauffage et de refroidissement pour une soudure "admissible" (courbe C I) et pour une soudure "défectueuse" (courbe C II) de composants à montage en surface. La figure 1 montre en abscisses la durée mesurée en secondes de la période de chauffage de l'échantillon, (O - t_{c}), puis de celle de la fenêtre de validation des mesures éffectuées pendant le refroidissement, (tc - tv), fenêtre pendant laquelle il sera procédé à la prise d'une image thermographique, par exemple à l'instant tm. Les valeurs des températures mesurées sont portées en ordonnées. L'origine des températures, correspondant à la température ambiante To dans l'espace du banc de contrôle, sert de point zéro pour les deux courbes.

D'une façon générale, les courbes de montée de température résultent de divers paramètres, principalement des caractéristiques physiques de la carte et de ses composants ainsi que du mode opératoire du chauffage. Par une régulation du chauffage appropriée à une carte déterminée, il est possible d'obtenir une allure de courbe prédéfinie. Si le chauffage doit être de courte durée pour éviter les risques de stabilisation thermique sur l'ensemble de la carte (à long terme les soudures seraient portées à une même température), il doit cependant être de durée suffisante pour porter la carte à une température de consigne appropriée pour obtenir en régime transitoire, en fin de chauffage, des écarts de température significatifs à la surface de la carte (et éviter, entre autres, les effets de l'inversion de température perceptible en tout début du chauffage, résultant de la moindre inertie thermique des soudures défectueuses). A titre d'exemple non limitatif, la puissance de chauffage a été, dans le cas présent, réduite progressivement aux abords de la température de consigne, ici choisie à 70°C. De plus, pour une chauffage de 20 à 70°C d'une durée moyenne de 10 secondes, des écarts de l'ordre de 5°C ont été détectés.

Pendant la phase de refroidissement les deux courbes évoluent sensiblement en parallèle puis se rapprochent pour revenir asymptotiquement vers la valeur To. Dans le cadre de l'invention, comme exposé ci-après, l'instant tv est choisi de façon à s'assurer que l'écart thermique détecté et utilisé pour la qualification du point de soudure contrôlé soit bien le reflet d'un apport insuffisant ou irrégulier de matière de soudure.

Le procédé selon l'invention met en application le phénomène physique qui vient d'être présenté. Plus précisément le procédé de contrôle selon l'invention comporte au moins les trois étapes suivantes :
- chauffage de courte durée de la carte de circuit imprimé équipée, par exemple de composants à montage en surface (CMS), (ou d'une portion étendue de cette carte),
- prise d'une image thermographique de la carte après l'arrêt du chauffage, de préférence dès l'arrêt de celui-ci,
- traitement de l'image par détection d'écart thermique par rapport à un étalon prédéfini pour des régions à contrôler de la carte , par exemple des aires d'accueil de soudures.

Dans le mode de mise en oeuvre du procédé selon l'invention ici décrit à titre d'exemple non limitatif, la prise d'image est effectuée en temps réel par une caméra infra-rouge du type à détecteur quantique (photo-excité) travaillant dans un domaine spectral compris entre 8 et 12 microns. Cette caméra mesure dans le spectre infra-rouge l'énergie calorifique rayonnée aux divers points de la carte en particulier aux aires de soudure et fournit un signal de mesure correspondant à la température de la surface élémentaire explorée. Pour éviter des rayonnements parasites des composants, la carte est laissée hors tension. Il est intéressant de remarquer que ce type de caméra utilisé permet d'une part de faire des mesures dans des domaines de températures peu élevées, de l'ordre par exemple de 70°C, sans risquer de détériorer la carte ou ses composants, d'autre part de procéder très rapidement à des prises d'images répétées avant un refroidissement de la carte trop important. De préférence pour une température de consigne de 70°C, l'écart thermique toléré pour une soudure "admissible" doit être inférieur à 3°C. Dans ces conditions la fenêtre de validité des mesures Vmax est choisie de l'ordre de 100 secondes.

Par ailleurs, pour assurer une bonne répétabilité du contrôle et éviter les problèmes de dispersion des mesures dus à des chauffages localement turbulents, il est prévu un chauffage laminaire par pyropanel à lampes de quartz. Plus précisément le chauffage est régulé, optionnellement préprogrammé à partir de la température instantanée prise en surface d'un point cible de la carte par un pyromètre. Par exemple, il est possible de réduire progressivement la puissance de chauffage aux abords de la température de consigne. Lorsque la température de consigne est atteinte, température de consigne choisie de préférence de l'ordre de 70°C, le chauffage est arrêté pour débuter la phase de prise d'image. Il est à remarquer que le choix d'un point cible thermiquement fiable (corps foncé présentant une bonne émissivité thermique, peu sensible aux aléas de fabrication des cartes à circuit imprimé équipées) permet d'obtenir une bonne base de référence nécessaire dans ce type de contrôle à caractère relatif.

Dans une variante du procédé selon l'invention la prise d'image est effectuée de façon séquentielle après découpage virtuel de la carte (ou de la portion étendue de celle-ci soumise au chauffage) en zones d'exploration unitaires correspondant au champ spatial couvert par la caméra. Par exemple l'appareillage qui sera décrit ci-après travaille avec des zones élémentaires de carte de dimensions égales à 35 x 26 mm pour des cartes dont les dimensions maximales sont de 500 x 400 mm. La figure 2 illustre schématiquement une carte avec ses axes OlXl,OlYl de coordonnées vraies locales et les points d'indexation et de repérage R1 à R2 de la carte par rapport à un support quelconque (par exemple le bâti du poste de montage des composants sur la carte). Sur la figure 2 sont également montrés schématiquement le point cible 10 pour le pyromètre et un composant monté en surface 12 (par exemple une résistance) avec ses deux aires d'accueil de soudure 14 et 16. Les zones élémentaires sont répertoriées ZEO,..ZEi. De plus un repérage géographique permet de localiser dans chaque zone les diverses régions et/ou soudures à contrôler. Plus précisément on réalise pour chaque modèle de carte une grille géographique qui servira de base à une image étalon avec laquelle sera comparée l'image de la carte à contrôler. D'une façon pratique, la grille de base est réalisée à partir de données qui ont été élaborées lors du dessin du circuit imprimé et de la carte complète avec l'aide d'un programme de Conception Assistée par Ordinateur, C.A.O.. L'image étalon est créée par mixage d'une pluralité d'images obtenues à partir de cartes de référence de même modèle. Optionnellement cette image étalon est paramétrée.

Selon l'invention, la carte est déplacée dès l'arrêt du chauffage hors du champ spatial du pyropanel pour positionner la zone ZEO par rapport au champ de la caméra. On procède ensuite au relevé d'une image thermique unitaire étant entendu que la position relative du champ de la caméra par rapport à la carte est transmise à la chaîne de traitement d'image pour permettre à celle-ci d'associer un point d'image à une localisation vraie sur la carte. Ainsi donc l'aire d'accueil d'une soudure défectueuse (comme toute autre région défectueuse) est identifiée, localisée et affichée. Au terme de chaque traitement d'image unitaire, la carte est déplacée latéralement par rapport au champ de la caméra pour permettre une nouvelle prise d'image jusqu'à épuisement des zones ZEi à explorer.

Il est entendu que le procédé selon l'invention peut donner lieu à un grand nombre de variantes, selon les désirs de l'expérimentateur et en tenant compte de chaque situation pratique. Néanmoins ces variantes devront respecter les trois phases opératoires caractéristiques de l'invention.

L'exposé qui précède a permis de mettre en évidence quelques avantages très intéressants du procédé selon l'invention. Parmi ceux-ci, il faut noter la facilité offerte par le procédé selon l'invention à une automatisation très poussée du contrôle de l'intégrité de la carte et tout particulièrement des soudures, automatisation qui permet d'éliminer l'intervention humaine dans l'appréciation des défauts de soudure. Par ailleurs le principe même d'un contrôle optique permet une résolution spatiale très fine entre deux régions ou deux aires d'accueil à contrôler, pour atteindre des valeurs inférieures au millimètre interdites à des appareils de type "planche à clous". Enfin, en faisant appel aux programmes informatiques et aux fichiers utilisés en C.A.O. pour le dessin de la carte à contrôler, il est possible de modifier la grille des régions à contrôler d'un modèle de carte et par là même les images étalons sans difficulté majeure ni délai important. D'autre avantages de l'invention apparaîtront à la lecture de la suite de la description et qui concerne plus particulièrement un mode de réalisation d'un appareillage pour mettre en oeuvre le procédé selon l'invention.

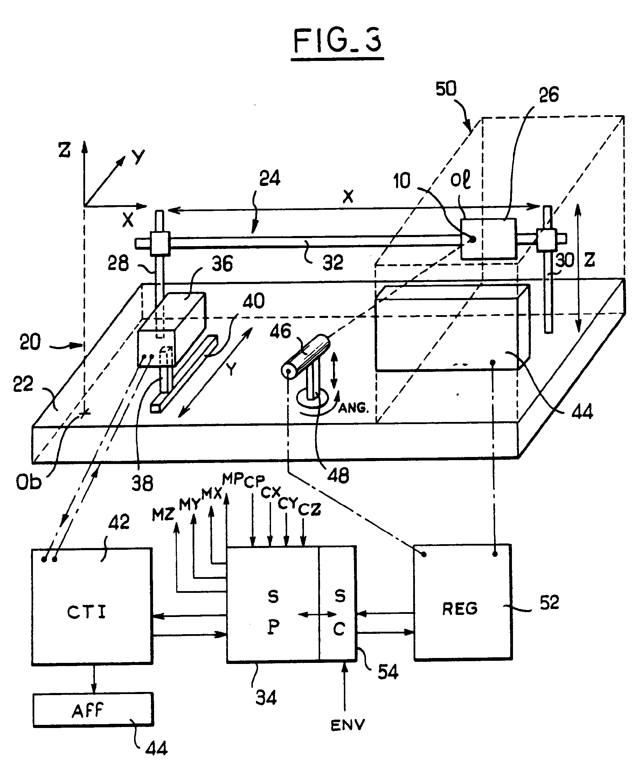

L'appareillage selon l'invention, illustré schématiquement à la figure 3, est structuré physiquement autour d'un support de carte 20 constitué d'un bâti 22, telle qu'une table optique anti-vibratoire en granit. La surface de la table comporte un réseau d'inserts taraudés permettant la fixation et le repérage spatial de divers éléments du banc de contrôle. Sur le bâti 22 sont solidarisés des moyens de guidage 24 pour la carte 26. Ces moyens de guidage se composent de rails en X plus précisément de deux rails verticaux 28 et 30 porteurs d'un rail horizontal 32 sur lequel peut également se déplacer un chariot mobile de type à déplacements bidirectionnels perpendiculaires (non représenté sur la figure 3), porteur de la carte 26. Le chariot présente des points de centrage qui, en coopération avec les repères R1-R2 de la carte, permettent le maintien mais aussi la localisation très précise de la carte 26 par rapport au bâti 22.

L'agencement ainsi décrit permet de définir un repère tridimensionnel en X, Y, Z, d'origine Ob, l'axe des X s'étendant parallèlement au rail horizontal 32, l'axe des Z (ou axe vertical) s'étendant parallèlement aux rails 28 et 30. Sur le chariot porteur de carte du rail 32 sont prévus deux moteurs pas à pas couplés avec des capteurs de position (MX et CX pour le déplacement du chariot mobile sur le rail 32, et MZ et CZ pour le positionnement vertical de la carte 26). Ces moteurs et capteurs (non représentés sur la figure 3 mais seulement identifiés) sont reliés à une station pilote SP 34 du type à calculateur digital. Ainsi donc la station pilote 34 est capable de repérer la localisation vraie du point Ob par rapport au point origine Ol de la carte et ainsi la localisation de chaque point de la carte notamment des aires d'accueil dont il faudra contrôler les soudures. De plus la station pilote commande les moteurs pas à pas MX et MZ de façon à permettre des déplacements par translation de la carte dans un plan parallèle au plan ObX,0bZ.

Le bâti 22 supporte également une caméra infra-rouge 36 montée sur un dispositif de pointage du champ de la caméra 38 lui-même monté coulissant sur une glissière 40 solidaire du bâti 22 et s'étendant parallèlement à l'axe des Y. Ici encore le mouvement du dispositif de pointage 38 du champ de la caméra (dans le mode de réalisation ici décrit, de la caméra elle-même) est commandé par un moteur pas à pas MY (non représenté) contrôlé par la station pilote 34 en fonction des informations données par le capteur associé CY. Ainsi la station pilote 34 est en mesure de faire un repérage instantané du positionnement relatif du champ de la caméra par rapport à la carte. Cette particularité importante pour la mise en oeuvre de l'invention peut toutefois, sans sortir du cadre de l'invention, être obtenue d'une autre façon que celle ici décrite (déplacements relatifs latéraux entre la carte et la caméra) notamment par l'intermédiaire d'un dispositif optique à balayage convenablement disposé dans le chemin optique objectif-caméra/carte. La caméra qui sera décrite plus en détail par la suite est reliée à une chaîne de traitement d'image CTI 42 du type à calculateur digital munie de son dispositif d'affichage 44 tel que écran-vidéo et/ou imprimante et/ou table traçante.

Le bâti 22 supporte également plusieurs composants d'une chaîne de chauffage plus particulièrement un pyropanel à lampes de quartz 44 et un pyromètre 46 monté sur un dispositif de calage 48. Le pyropanel 44 est disposé dans une enceinte en matériau réfractaire 50 montée à la droite du bâti 22 si l'on considère la figure 3. De cette façon le chauffage de la carte intervient dans cette enceinte 50 tandis que la prise d'image thermique est réalisée après déplacement de la carte vers la caméra, c'est à dire vers le côté gauche du bâti pour éviter tout rayonnement parasite venant de la chaîne de chauffage. Un écran thermique (non représenté) est disposé autour de la carte pour protéger les rails de guidage et les moteurs de l'énergie de chauffage rayonnée par le pyropanel. Dans l'appareillage de test ici décrit, la puissance de chauffage est assez élevée 20 KW pour obtenir un temps de chauffage assez court (passage de la carte de 20°C à 70°C à mi-puissance en moins de 10 sec.). Le chauffage est commandé par un régulateur 52 lui-même sous le contrôle d'une station de contrôle SC 54. L'opérateur est ainsi en mesure de pré-programmer la courbe de chauffage et le nombre de lampes de quartz en service en fonction de la dimension de la carte à contrôler, étant entendu que le dispositif utilisé permet d'obtenir un chauffage laminaire sans turbulence thermique locale.

Le pyromètre 46 est du type à détecteur pyroélectrique travaillant dans une bande spectrale de 8 à 12 microns. Le détecteur correctement calé sur la cible 10 de la carte détecte l'énergie émise par la surface de la cible (d'un diamètre moyen de 5 mm) et fournit une tension de sortie correspondant à la température de cette surface. Le signal est transmis au régulateur qui arrête le chauffage dès que la température de consigne (70°C) affichée par la station de contrôle est atteinte. Dans l'appareillage ici décrit, le pyromètre et son convertisseur-afficheur, commercialisés sous la marque LAND par la Société SCHLUMBERGER, permettent d'obtenir une précision inférieure à 0,5°C. Le dispositif de calage du pyromètre 48 comporte une platine tournante à 360° et est pourvu de moteurs pas à pas (identifiés globalement sous l'appelation MP) et de capteurs (CP) susceptibles de positionner le pyromètre en hauteur (axe des Z) et en direction (angle de rotation ANG). Les moteurs MP et les capteurs CP sont convenablement reliés à la station pilote 34 pour effectuer un calage automatique du pyromètre pour un modèle de carte donné.

La station pilote 34 et la station de contrôle 54 sont regroupées et placées sous le contrôle de l'unité centrale d'un micro-ordinateur BULL MICRAL modèle 40 (BM 40) convenablement chargé d'un logiciel de commande. Malgré des courses utiles assez importantes des moyens de guidage 24 et de la glissière 40, X=1250 mm, Y=630 mm, Z=400 mm, la précision géographique obtenue est de l'ordre de 0,01 mm en utilisant des moteurs dont le pas unitaire de déplacement est de 0,127 mm.

La caméra infra-rouge 36 utilisée est commercialisée par la société INFRAMETRICS de Bedford (E.U.A.) sous l'appellation "Modèle 600". Plus précisément cette caméra du type à balayage avec un entrelacement d'ordre 2, est équipée d'un détecteur quantique Hg-Cd-Te refroidi à l'azote liquide opérant dans une bande spectrale de 8 à 12 microns. Le champ de la caméra est défini par l'angle de balayage du détecteur soit 20° H(horizontal) et 15° V(vertical). Ceci permet une résolution de 256 points images sur 240 lignes. En choisissant un réglage de la caméra correspondant à un recouvrement par la caméra d'une zone unitaire d'exploration de 35 x 26 mm, on obtient une résolution vraie sur la carte de 0,13 mm/H et de 0,11 mm/V. Le signal de mesure fourni par chaque point image est numérisé sous 7 bits, ce qui correspond à 128 niveaux de luminance thermique mesurables. La précision obtenue est de l'ordre de 0,1°C. La vitesse de prise d'image thermique est assez élevée de l'ordre de 20 millisecondes pour la trame et de 55 microsecondes par ligne.

A la réception d'un ordre de relevé d'image unitaire, la caméra transmet à la chaîne CTI 42, par l'intermédiaire d'un convertisseur digital, un bloc d'informations comportant le signal "video" représentatif de la mesure de la température en un point de la carte accompagné de signaux de synchronisation permettant de positionner les débuts des balayages lignes et trames (et par voie de conséquence d'effectuer le repérage des points images). La chaîne de traitement d'image CTI 42 est structurée autour d'un micro-ordinateur BULL MICRAL Modèle 60 (BM 60), asservi comme expliqué par la suite à la station pilote 34 c'est à dire au micro BM 40. Le sous-système informatique constituant la chaîne CTI 42 présente une capacité de mémoire centrale et périphérique suffisante pour traiter et conserver des "images" de cartes dont chaque unité demande une capacité disponible de 128 Koctets. Ce sous-système informatique comporte outre des moyens de stockage d'un bloc d'informations provenant du convertisseur de la caméra, les moyens matériels et logiciels pour déterminer, à partir d'un signal de numéro d'ordre du relevé d'image et transmis par la station pilote 34, la localisation vraie des points objets associés à chaque point image et ainsi d'apparier une localisation vraie sur la carte à chaque signal de mesure. La première phase du traitement de l'image se termine par la mise en mémoire de l'image ainsi retraitée ou de parties prédéfinies de celle-ci selon une grille géographique préétablie et existante dans un fichier de la chaine CTI 42.

La chaîne CTI comporte également en mémoire une image étalon formée selon la même grille correspondante à un modèle de carte prédéterminé. L'image étalon peut être créée de toute pièce par programmation, cependant il s'est avéré intéressant et plus rapide de créer cette image par mixage d'une pluralité d'images thermographiques obtenues dans les mêmes conditions à partir de l'exploration d'au moins dix cartes réputées admissibles, par exemple par moyennage des valeurs mesurées. Bien évidemment sans sortir du cadre de l'invention, cette image étalon peut être retravaillée à l'aide de logiciels mettant en jeu divers paramétrages. Par exemple il est intéressant de parametrer certaines valeurs étalons pour tenir compte de la structure physique de l'occupant de la région à contrôler. En effet le seuil d'écart fixé à 3°C pour le contrôle des soudures n'est pas toujours approprié pour certains composants dont on veut vérifier la présence et le montage correct (en position et en orientation). Ces composants tels les résistances, les condensateurs, les boitiers de transistors ou de circuits intégrés (avec leurs pattes de fixation) présentent des caractéristiques thermiques différentes (capacité calorifique et émissivité) suffisamment distinctes de celles des soudures qu'il s'avère opportun de modifier le seuil d'écart thermique pour les régions à explorer correspondantes.

La chaîne CTI est ainsi en mesure de faire une comparaison point par point (limitée à ceux présélectionnés de la grille) des signaux de mesure avec les valeurs étalons et afficher au travers des moyens d'affichage 44, l'identification et la localisation de la région défectueuse, par exemple de l'aire de soudure dans laquelle la température de surface d'au moins un point élémentaire exploré de la carte (0,13x0,11 mm) est inférieure de plus de 3°C à la température étalon au même point.

On peut remarquer que l'analyse ainsi faite est très fine car une aire d'accueil de soudure a une surface moyenne de 1.5 mm2 soit 100 fois la résolution de l'appareillage de test. L'appareillage selon l'invention permet ainsi de renseigner sur la qualité même du défaut (fissure, bavure, cheveux) et sur sa localisation dans l'aire de soudure et de prévoir s'il y a lieu les modifications à apporter lors de la préparation et l'opération de soudure. De même l'appareillage selon l'invention permet d'effectuer aisément toutes les opérations de comptage et statistiques souhaitées pour assiter la mise au point et le contrôle d'un processus de fabrication automatique.

Pour chaque nouveau modèle de carte, l'opérateur procédera aux opérations préalables suivantes :
- Détermination, à partir des fichiers et programmes C.A.O. correspondants aux dessins de la carte, de la grille géographique des régions, en particulier des aires de soudure, à contrôler et chargement d'un fichier "grille" particulier en mémoire dans le sous-système informatique BM 60 de la chaîne 42.
- Détermination à partir du fichier "grille" de la position de la cible et chargement en mémoire de cette position. Ce chargement peut se faire indifféremment dans le sous-système BM 60 ou dans le sous-système BM 40.
- Découpage virtuel de la carte à partir du fichier "grille" en zones d'exploration élémentaires et mise en mémoire dans les sous-systèmes BM 40 et BM 60 de la séquence des positionnements relatifs caméra/carte de chaque zone d'exploration unitaire.
- Sélection pour la station de contrôle 54 de la température de consigne.
- Sélection d'une dizaine de cartes réputées admissibles et réalisation des relevés des images thermographiques de référence correspondantes.
- Elaboration de l'image étalon par mixage et paramétrage éventuel des images de référence. (A noter qu'il est possible de tester les images de référence par rapport à l'image étalon et de faire des études de dispersion selon les régions et en particulier les aires d'accueil à contrôler).
- Mise en mémoire de l'image étalon.

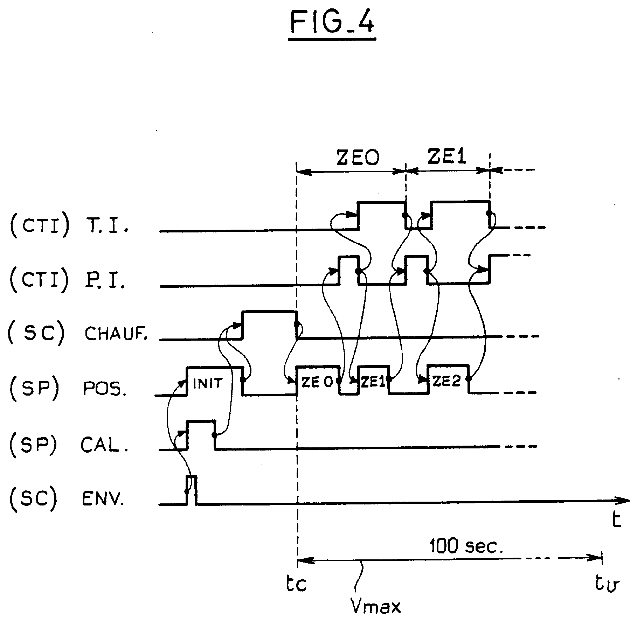

Ainsi donc les sous-systèmes informatiques BM 40 et BM 60 sont chargés de leurs logiciels d'exploitation et des fichiers adaptés aux divers modèles de cartes à contrôler. Il est alors possible de procéder au contrôle d'une carte de série selon un modèle prérépertorié au sortir de la fabrication. Ce contrôle se déroule de la façon décrite ci-après en se référant au chronogramme de la figure 4 :
. Après la mise en place de la carte sur son chariot, l'opérateur donne un top manuel (ENV=1) à la station de contrôle SC 54. Cette dernière coordonne avec la station pilote SP 34 la mise en position initiale INIT de la carte dans l'enceinte réfractaire 50 (POS=1) et le calage correct du pyromètre 46 sur le point cible 10 de la carte (CAL=1). Un signal de fin de préparation (CAL=0 ET POS=0) est émis par la station pilote 34 vers la station de contrôle 54 qui peut ainsi faire commencer la phase de chauffage proprement dite (CHAUF=1).

Dès que la température de consigne est atteinte à la surface de la cible, un signal de fin de chauffage (CHAUF=0) est émis de la station de contrôle 54 vers la station pilote 34 qui prend le relais (POS=1). Après un déplacement de la carte hors de l'enceinte réfractaire 50, la station pilote 34 positionnera la carte par rapport à la caméra de façon à faire couvrir par cette dernière la zone élémentaire ZEO, un signal de fin de transport (POS=0) sera alors généré dans la station pilote 34. La station pilote transmettra alors à la chaîne CTI 42 un top de prise d'image (P.I.=1) par la caméra. Grâce à l'automatisation poussée de l'appareillage selon l'invention, l'intervalle de temps entre le signal de fin de chauffage (CHAUF=0) et le premier top de prise d'image (P.I.=1) ne dépasse pas quelques secondes. L'image de la caméra est ainsi relevée en temps réel et transmise vers la chaîne de traitement d'image CTI 42 qui reçoit de plus de la station pilote, avec le top de prise d'image (P.I.=1), un signal significatif du numéro d'ordre de la zone d'exploration par le champ de la caméra. Grâce à ce signal la chaîne CTI 42 est en mesure de restituer la localisation vraie de chaque point objet exploré pour lequel un signal de mesure est généré par le convertisseur digital de la caméra 36. Un signal de fin de relevé d'image (P.I.=0) est alors transmis par la chaîne CTI 42 à la station pilote 34 qui peut positionner la caméra par rapport à une nouvelle zone d'exploration de la carte (POS=1), en fait par translation de la carte. Entre-temps la chaîne CTI 42 procède à la reconstruction de l'image en localisation vraie et au test de comparaison (T.I.=1). Les résultats de ce test de comparaison sont mis sur une mémoire tampon pour être affichés en temps différé. Par contre dès la fin du traitement de l'image proprement dite, un top de fin de traitement (T.I.=0) est adressé à la station pilote 34 par la chaîne CTI 42. Dans le cas ici illustré, ce top survient après la génération du signal de fin de transport (POS=0) pour une simple raison de durée du temps de traitement.

Dès perception par la station pilote 34 des deux signaux de fin de traitement d'image (T.I.=0) et de fin de transport (POS=0), la station pilote 34 émet un nouveau signal de top de prise d'image (P.I.=1) avec l'indication du numéro d'ordre de la nouvelle zone à explorer ZE1. Ceci se répétera jusqu'à épuisement de la séquence des zones à explorer ZEi à moins que le temps écoulé depuis la génération du signal de fin de chauffage (CHAUF=0) n'est dépassé la durée de validation Vmax (par exemple 100 secondes). Dans cette dernière éventualité, la station pilote 34 commande une nouvelle opération de chauffage de la carte pour permettre de continuer l'exploration thermographique de celle-ci.

## Revendications

1. Procédé pour le contrôle d'une carte (26) de circuit imprimé équipée, caractérisé en ce qu'il comporte au moins les phases suivantes :
- chauffage continu et de courte durée de la carte (26) jusqu'à ce qu'une température de consigne appropriée pour obtenir des écarts de température significatifs à la surface de la carte soit mesurée en un point cible sur la carte ;
- définition d'une fenêtre de validation des mesures effectuées après que le chauffage ait cessé ;
- prise d'une image thermographique de la carte pendant cette fenêtre de validation des mesures, l'image thermographique consistant en des mesures de température instantanées, en fonction de la position de la carte à un instant donné pendant la fenêtre de validation des mesures ;
- et traitement de l'image par détection d'écart thermique de l'image thermographique de la carte par rapport à une image thermographique standard prédéfinie.

2. Procédé selon la revendication 1 dans lequel l'étape de traitement est caractérisé en ce que l'écart thermique maximum considéré comme admissible pour le contrôle des soudures est choisi en fonction de la température moyenne en surface de la carte (26) à l'instant d'arrêt du chauffage.

3. Procédé selon la revendication 2, caractérisé en ce que le seuil d'écart thermique admissible est fixé à 3°C pour une température de chauffage moyenne de l'ordre de 70°C.

4. Procédé selon l'une des revendications précédentes, caractérisé en ce que l'arrêt du chauffage est commandé lorsque la température de surface d'un point cible (10) de la carte atteint une valeur de consigne de l'ordre de 70°C.

5. Procédé selon la revendication 4, caractérisé en ce que le chauffage de la carte est régulé en fonction d'une courbe de montée en température prédéfinie, avec réduction progressive de la puissance de chauffage aux abords de la température de consigne.

6. Procédé selon l'une des revendications précédentes, caractérisé en ce que le chauffage de la carte (26) est réalisé de façon laminaire.

7. Procédé selon l'une des revendications précédentes, caractérisé en ce que la prise d'image est effectuée en temps réel par une caméra infrarouge (36), travaillant dans un domaine spectral compris entre 8 et 12 microns après le déplacement de la carte hors de la zone de chauffage dès l'arrêt du chauffage.

8. Procédé selon la revendication 7 caractérisé en ce que la prise d'image n'est autorisée que pendant une période de validation (Vmax) commençant à l'instant d'arrêt de la phase de chauffage et dont la durée est dépendante de l'écart thermique maximum acceptable, une période de validation ayant une durée de 100 secondes pour une température de chauffage moyenne de 70°C et un écart thermique maximum de 3°C.

9. Procédé selon l'une des revendications précédentes, caractérisé en ce qu'une image étalon est définie pour chaque modèle de carte avec un repérage géographique à deux dimensions de la localisation de points sélectionnés du circuit imprimé et des composants équipant ledit circuit imprimé.

10. Procédé selon les revendications 7 et 9 prises en combinaison, caractérisé en ce que le repérage géographique est associé à un découpage virtuel de la carte en zones d'exploration unitaires (ZEi) correspondant au champ spatial de la caméra infra-rouge (36), ledit repérage géographique réalisant la localisation vraie à l'intérieur de chaque zone d'exploration (ZEi) des diverses régions à contrôler.

11. Procédé selon la revendication 10, caractérisé en ce qu'il est prévu l'affichage de la localisation de la région reconnue défectueuse.

12. Procédé selon les revendications 10 et 11, caractérisé en ce que l'opération de détection d'écart thermique n'est effectuée que sur les portions d'images correspondant à une grille géographique prédéfinie des régions à contrôler.

13. Procédé selon l'une des revendications 10 à 12, caractérisé en ce que la prise d'image complète de la carte (26) est obtenue par déplacement relatif latéral du champ de la caméra par rapport à la carte, chaque positionnement caméra/carte correspondant au recouvrement par le champ de la caméra d'une zone d'exploration unitaire (ZEi).

14. Procédé selon l'une des revendications précédentes, caractérisé en ce que l'étalon prédéfini est créé par mixage d'une pluralité d'images obtenues à partir de cartes de référence de même modèle réputées admissibles, ledit étalon étant optionnellement paramétrable.

15. Procédé selon l'une des revendications précédentes, caractérisé en ce qu'il est utilisé pour le contrôle des soudures de cartes de circuit imprimé (26) équipées de composants à montage en surface (12) (CMS).

16. Appareillage pour la mise en oeuvre du procédé selon l'une des revendications précédentes comportant :
- un support (20) de carte (26) ;
- une chaîne de chauffage (44,46,48,52) ;
- une chaîne de prise d'image, comportant une caméra infrarouge (36) et un convertisseur générant par relevé d'image unitaire un bloc d'informations ;
- une chaîne de traitement d'image (42) comportant des moyens de stockage du bloc d'informations correspondant au relevé d'image unitaire ;
- des moyens de stockage d'une image étalon constituée d'un ensemble de signaux étalons, chaque signal étalon étant apparié avec la localisation vraie d'un point objet quelconque de la carte (26) ;
- des moyens de comparaison, pour une même localisation vraie, d'un signal de mesure avec le signal étalon ;
- et des moyens d'affichage (44) de la localisation vraie concernée et du résultat de l'opération de comparaison ;
caractérisé en ce que :
- le support de carte (20) est muni d'un agencement permettant le repérage géographique (CX, CY, CZ, 34) à deux dimensions de ladite localisation vraie,
- le bloc d'information de la chaîne de prise d'image comporte pour chaque point image du champ image de la caméra la localisation image correspondante et le signal de mesure représentatif de la température au point objet associé de la carte (26) couvert par le champ élémentaire objet de la caméra (36),
- un dispositif de pointage (38) du champ de la caméra (36) associé audit support de carte (20), ledit agencement de repérage géographique (CX,CY,CZ,34) étant adapté pour effectuer le repérage du positionnement du champ de la caméra par rapport à la carte,
- la chaîne de traitement d'image (42) comportant également :
. des moyens associés audit agencement de repérage géographique (CX,CY,CZ,34), pour déterminer la localisation vraie du point objet associé à une localisation image donnée du bloc d'information correspondant au relevé d'image unitaire donné et pour apparier chaque signal de mesure à la localisation vraie correspondante.

17. Appareillage selon la revendication 16 caractérisé en ce que ledit support (20) de carte (26) comporte aussi un bâti fixe (22) portant ledit dispositif de pointage (38) du champ de la caméra et muni de moyens de guidage (24) de la carte (26).

18. Appareillage selon la revendication 17, caractérisé en ce que ledit agencement de repérage géographique (CX, CY, CZ, 34) est de type tridimensionnel et comporte une station pilote (34) pour effectuer le repérage du positionnement du champ de la caméra (36) et commander des moyens d'actionnement (MX,MY,MZ) desdits moyens de guidage (24) et dudit dispositif de pointage (38) pour permettre des déplacements relatifs entre la carte (26) et le champ de la caméra (36).

19. Appareillage selon l'une des revendications 17 et 18, caractérisé en ce que les moyens de guidage (24) de la carte comportent un jeu de rails de guidage (28,30,32) et un chariot porteur de carte (26) pour permettre le déplacement de la carte dans deux directions perpendiculaires (X,Z).

20. Appareillage selon la revendication 19, caractérisé en ce que le dispositif de pointage (38) du champ de la caméra est susceptible de déplacement selon une direction normale (Y) au plan de déplacement (X,Z) dudit chariot.

21. Appareillage selon l'une des revendications 18 à 20, caractérisé en ce que une station pilote (34) commande les chaînes de prise et de traitement d'image (36,42) et gère un processus de relevé et de traitement d'images unitaires de façon séquentielle à partir d'un découpage virtuel de la carte en zones élémentaires d'exploration (ZEi) correspondant au champ objet de la caméra couvert par une image unitaire.

22. Appareillage selon la revendication 21, caractérisé en ce que ladite station pilote (34) génère les ordres de relevé d'image unitaire en fonction d'un programme prédéfini d'exploration géographique de la carte.

23. Appareillage selon l'une des revendications 21 et 22, caractérisé en ce que ladite station pilote (34) transmet auxdits moyens pour apparier chaque signal de mesure à la localisation vraie correspondante, présents dans ladite chaîne de traitement d'image (42), des informations concernant le positionnement instantané du champ de la caméra par rapport à la carte utilisée lors de chaque relevé d'image unitaire.

24. Appareillage selon l'une des revendications 21 à 23, caractérisé en ce que la station pilote (34) commande un déplacement relatif entre la carte (26) et le champ de la caméra (36) après chaque relevé d'image unitaire.

25. Appareillage selon les revendications 16 et 21 prises en combinaison, caractérisé en ce que la station pilote (34) débute ledit processus de prise et de traitement d'image à la réception d'un signal de début issu par la station de contrôle (54).

## Patentansprüche

1. Verfahren zur Prüfung einer bestückten Leiterplatte (26), dadurch gekennzeichnet, daß es wenigstens die folgenden Phasen enthält:
- ununterbrochene und kurz andauernde Erwärmung der Karte (26), bis an einem Zielpunkt auf der Karte eine geeignete Nenntemperatur gemessen wird, bei der auf der Oberfläche der Karte deutliche Temperaturunterschiede erhalten werden;
- Festlegen eines Fensters, in dem die nach der Beendigung der Erwärmung ausgeführten Messungen für gültig erklärt werden;
- Aufnehmen eines thermographischen Bildes der Karte in diesem Fenster gültiger Messungen, wobei das thermographische Bild aus momentanen Temperaturmessungen besteht, die von der Position der Karte in einem gegebenen Zeitpunkt in dem Fenster gültiger Messungen abhängen;
- und Verarbeiten des Bildes durch Erfassung des Temperaturunterschiedes zwischen dem thermographischen Bild der Karte und einem im voraus festgelegten thermographischen Standard-Bild.

2. Verfahren gemäß Anspruch 1, in dem die Stufe der Verarbeitung dadurch gekennzeichnet ist, daß der für die Prüfung der Lötstellen als zulässig angesehene maximale Wärmeunterschied in Abhängigkeit von der mittleren Temperatur auf der Oberfläche der Karte (26) im Zeitpunkt des Beendens der Erwärmung gewählt wird.

3. Verfahren gemäß Anspruch 2, dadurch gekennzeichnet, daß der Schwellenwert des zulässigen Temperaturunterschiedes für eine mittlere Erwärmungstemperatur in der Größenordnung von 70°C auf 3°C festgesetzt ist.

4. Verfahren gemäß einem der vorangehenden Ansprüche, dadurch gekennzeichnet, daß die Beendigung des Erwärmens befohlen wird, wenn die Oberflächentemperatur eines Zielpunktes (10) der Karte einen Nennwert in der Größenordnung von 70°C erreicht.

5. Verfahren gemäß Anspruch 4, dadurch gekennzeichnet, daß die Erwärmung der Karte in Abhängigkeit von einer im voraus festgelegten Temperaturanstiegskurve mit progressiver Verringerung der Heizleistung in der Umgebung der Nenn-Temperatur reguliert wird.

6. Verfahren gemäß einem der vorangehenden Ansprüche, dadurch gekennzeichnet, daß die Erwärmung der Karte (26) laminar ausgeführt wird.

7. Verfahren gemäß einem der vorangehenden Ansprüche, dadurch gekennzeichnet, daß die Aufnahme des Bildes mittels einer Infrarotkamera (36), die in einem Spektralbereich von acht bis zwölf Mikron arbeitet, nach der Verschiebung der Karte aus der Erwärmungszone gleich nach Beendigung der Erwärmung in Echtzeit ausgeführt wird.

8. Verfahren gemäß Anspruch 7, dadurch gekennzeichnet, daß die Aufnahme des Bildes nur während einer Gültigkeitsperiode (Vmax) zugelassen wird, die im Zeitpunkt der Beendigung der Erwärmungsphase beginnt und deren Dauer von dem annehmbaren maximalen Wärmeunterschied abhängt, wobei eine Gültigkeitsperiode für eine mittlere Erwärmungstemperatur von 70°C und einen maximalen Wärmeunterunterschied von 3°C eine Dauer von 100 Sekunden besitzt.

9. Verfahren gemäß einem der vorangehenden Ansprüche, dadurch gekennzeichnet, daß für jeden Kartentyp ein Normalbild definiert ist, das eine zweidimensionale geographische Markierung zur Lokalisierung von ausgewählten Punkten der gedruckten Schaltung und der Bauelemente, mit denen die gedruckte Schaltung bestückt ist, aufweist.

10. Verfahren gemäß den Ansprüchen 7 und 9 in Kombination, dadurch gekennzeichnet, daß die geographische Markierung einem virtuellen Zerschneiden der Karte in einzelne Abtastzonen (ZEi) entspricht, die ihrerseits dem räumlichen Feld der Infrarotkamera (36) entsprechen, wobei die geographische Markierung die wahre Lokalisierung innerhalb jeder Abtastzone (ZEi) der verschiedenen zu prüfenden Bereiche bewerkstelligt.

11. Verfahren gemäß Anspruch 10, dadurch gekennzeichnet, daß die Anzeige der Lokalisierung des erkannten fehlerhaften Bereichs vorgesehen ist.

12. Verfahren gemäß den Ansprüchen 10 und 11, dadurch gekennzeichnet, daß der Vorgang der Erfassung des Temperaturunterschiedes nur in denjenigen Bildabschnitten ausgeführt wird, die einem im voraus festgelegten Vermessungsgitter der zu prüfenden Bereiche entsprechen.

13. Verfahren gemäß einem der Ansprüche 10 bis 12, dadurch gekennzeichnet, daß die Aufnahme des vollständigen Bildes der Karte (26) durch relative seitliche Verschiebung des Feldes der Kamera in bezug auf die Karte erhalten wird, wobei jede Positionierung Kamera/Karte einer Abdeckung einer einzigen Abtastzone (ZEi) durch das Kamerafeld entspricht.

14. Verfahren gemäß einem der vorangehenden Ansprüche, dadurch gekennzeichnet, daß das im voraus festgelegte Normal durch Mischen von mehreren Bildern erzeugt wird, die ausgehend von als zulässig angesehenen Referenzkarten desselben Typs erhalten werden, wobei das Normal wahlweise parametriert werden kann.

15. Verfahren gemäß einem der vorangehenden Ansprüche, dadurch gekennzeichnet, daß es für die Prüfung von Lötstellen der mit oberflächenmontierten Bauelementen (12) (CMS) bestückten Leiterplatten (26) verwendet wird.

16. Apparatur zur Ausführung des Verfahrens gemäß einem der vorangehenden Ansprüche, mit:
- einem Träger (20) der Karte (26);
- einer Heizkette (44, 46, 48, 52);
- einer Bildaufnahmekette, die eine Infrarotkamera (36) sowie einen Wandler enthält, der durch Einzelbildvermessung einen Block von Informationen erzeugt;
- einer Bildverarbeitungskette (42), die Speichermittel für den der Einzelbildvermessung entsprechenden Block von Informationen enthält;
- Mitteln zum Speichern eines Normalbildes, das von einer Gesamtheit von Normalsignalen gebildet ist, wobei jedes Normalsignal mit der wahren Lokalisierung eines beliebigen Gegenstandspunkts der Karte (26) gepaart wird;
- Mitteln für den Vergleich eines Meßsignals mit dem Normalsignal für dieselbe wahre Lokalisierung;
- und Mitteln für die Anzeige (44) der betreffenden wahren Lokalisierung und des Ergebnisses des Vergleichsvorgangs;
dadurch gekennzeichnet, daß;
- der Kartenträger (20) mit einer Anordnung versehen ist, die die zweidimensionale geographische Markierung (CX, CY, CZ, 34) der wahren Lokalisierung gestattet,
- der Block von Informationen der Bildaufnahmekette für jeden Bildpunkt des Bildfeldes der Kamera die entsprechende Bildlokalisierung sowie das Meßsignal enthält, das die Temperatur im zugehörigen und von dem elementaren Gegenstandsfeld der Kamera (36) abgedeckten Gegenstandspunkt der Karte (26) darstellt,
- eine Ausrichteinrichtung (38) für das Feld der Kamera (36) vorgesehen ist, die mit dem Kartenträger (20) verbunden ist, wobei die Anordnung zur geographischen Markierung (CX, CY, CZ, 34) so beschaffen ist, daß sie die Markierung der Position des Kamerafeldes in bezug auf die Karte bewerkstelligt,
- die Bildverarbeitungskette (42) außerdem enthält:
. Mittel, die der Anordnung zur geographischen Markierung (CX, CY, CZ, 34) zugehören, um die wahre Lokalisierung des Gegenstandspunkts zu bestimmen, der einer gegebenen Bildlokalisierung des der gegebenen Einzelbildvermessung entsprechenden Blocks von Informationen zugehört, und um jedes Meßsignal mit einer entsprechenden wahren Lokalisierung zu paaren.

17. Apparatur gemäß Anspruch 16, dadurch gekennzeichnet, daß der Träger (20) der Karte (26) außerdem einen festen Rahmen (22) enthält, der die Ausrichteinrichtung (38) des Kamerafeldes trägt und mit Mitteln (24) zum Führen der Karte (26) versehen ist.

18. Apparatur gemäß Anspruch 17, dadurch gekennzeichnet, daß die Anordnung zur geographischen Markierung (CX, CY, CZ, 34) vom dreidimensionalen Typ ist und eine Sucherstation (34) enthält, um die Markierung der Positionierung des Feldes der Kamera (36) auszuführen und Betätigungsmittel (MX, MY, MZ) der Führungsmittel (24) und der Ausrichteinrichtung (38) zu steuern, um relative Verschiebungen zwischen der Karte (26) und dem Feld der Kamera (36) zu gestatten.

19. Apparatur gemäß einem der Ansprüche 17 und 18, dadurch gekennzeichnet, daß die Führungsmittel (24) der Karte eine Gruppe von Führungsschienen (28, 30, 32) und einen Trägerschlitten für die Karte (26) aufweisen, um die Verschiebung der Karte in zwei zueinander senkrechten Richtungen (X, Z) zu gestatten.

20. Apparatur gemäß Anspruch 19, dadurch gekennzeichnet, daß die Ausrichteinrichtung (38) für das Feld der Kamera in einer zur Verschiebungsebene (X, Z) des Schlittens senkrechten Richtung (Y) verschoben werden kann.

21. Apparatur gemäß einem der Ansprüche 18 bis 20, dadurch gekennzeichnet, daß eine Sucherstation (34) die Bildaufnahme- und Bildverarbeitungsketten (36, 42) steuert und einen Einzelbildvermessungs- und -verarbeitungsprozeß sequentiell und ausgehend von einem virtuellen Zerschneiden der Karte in elementare Abtastzonen (ZEi), die dem von einem Einzelbild abgedeckten Gegenstandsfeld der Kamera entsprechen, leitet.

22. Apparatur gemäß Anspruch 21, dadurch gekennzeichnet, daß die Sucherstation (34) die Reihenfolgen der Einzelbildvermessungen in Abhängigkeit von einem im voraus festgelegten Programm zur geographischen Abtastung der Karte erzeugt.

23. Apparatur gemäß einem der Ansprüche 21 und 22, dadurch gekennzeichnet, daß die Sucherstation (34) an die Mittel zum Paaren eines jeden Meßsignals mit der entsprechenden wahren Lokalisierung, welche in der Bildverarbeitungskette (42) vorhanden sind, Informationen überträgt, die die momentane Positionierung des Feldes der Kamera in bezug auf die Karte betreffen, die bei jeder Einzelbildvermessung verwendet wird.

24. Apparatur gemäß einem der Ansprüche 21 bis 23, dadurch gekennzeichnet, daß die Sucherstation (34) eine relative Verschiebung zwischen der Karte (26) und dem Feld der Kamera (36) nach jeder Einzelbildvermessung steuert.

25. Apparatur gemäß den Ansprüchen 16 und 21 in Kombination, dadurch gekennzeichnet, daß die Sucherstation (34) den Prozeß der Bildaufnahme und -verarbeitung bei Empfang eines von der Prüfstation (54) ausgegebenen Anfangssignals beginnt.

## Claims

1. A process for checking an equipped printed circuit board (26), characterised in that it comprises at least the following phases:
- continuous, short-duration heating of the board (26) until a control temperature, appropriate for obtaining significant deviations in temperature on the surface of the board, is measured at a target point on the board;
- defining a window for validating measurements made after the heating is stopped;
- taking a thermographic image of the board during this window for validating measurements, the thermographic image consisting in instantaneous temperature measurements, as a function of the position of the board at a given moment during the measurement-validation window;
- and processing the image by detecting a thermal deviation of the thermographic image of the board, relative to a standard pre-defined thermographic image.

2. A process according to Claim 1, in which the processing stage is characterised in that the maximum thermal deviation considered admissible for checking solder joints is chosen as a function of the average temperature on the surface of the board (26) at the moment when heating is stopped.

3. A process according to Claim 2, characterised in that the threshold of admissible thermal deviation is fixed at 3°C for an average heating temperature of the order of 70°C.

4. A process according to one of the preceding claims, characterised in that the stopping of heating is commanded when the surface temperature of a target point (10) on the board reaches a control value of the order of 70°C.

5. A process according to Claim 4, characterised in that the heating of the board is regulated as a function of a pre-defined curve for temperature rise, with a progressive reduction in heating power in the area of the control temperature.

6. A process according to one of the preceding claims, characterised in that the board (26) is heated in a laminar manner.

7. A process according to one of the preceding claims, characterised in that the image is taken in real time by an infrared camera (36), working in a spectral region comprised between 8 and 12 microns after the board is displaced out of the heating zone as soon as heating is stopped.

8. A process according to Claim 7, characterised in that the taking of the image is authorised only during a validation period (Vₘₐₓ), starting at the moment that the heating phase ends, the duration of which is dependent on the maximum acceptable thermal deviation, a validation period having a duration of 100 seconds for an average heating temperature of 70°C and a maximum thermal deviation of 3°C.

9. A process according to one of the preceding claims, characterised in that a standard image is defined for each model of board with a two-dimensional geographic identification of the location of selected points of the printed circuit and of the components with which said printed circuit is equipped.

10. A process according to Claims 7 and 9 taken in combination, characterised in that the geographical identification is combined with a virtual cutting up of the board into unitary exploration zones (ZEi) corresponding to the spatial field of the infrared camera (36), said geographic identification producing the true location inside each exploration zone (ZEi) of the various regions to be checked.

11. A process according to Claim 10, characterised in that provision is made for displaying the location of the region recognised to be defective.

12. A process according to Claims 10 and 11, characterised in that the operation for detecting thermal deviation is carried out only on the portions of images corresponding to a predefined geographical grid of the regions to be checked.

13. A process according to one of Claims 10 to 12, characterised in that the complete image of the board (26) is taken by relative lateral displacement of the field of the camera relative to the board, each camera/board position corresponding to the covering by the field of the camera of one unitary exploration zone (ZEi).

14. A process according to one of the preceding claims, characterised in that the predefined standard is created by mixing a plurality of images obtained from reference boards of the same model deemed to be admissible, said standard being optionally capable of having parameters assigned to it.

15. A process according to one of the preceding claims, characterised in that it is used for checking the solder joints of printed circuit boards (26) fitted with surface-mounted components (12) (CMS).

16. Equipment for implementing the process according to one of the preceding claims, comprising:
- a holder (20) for a board (26);
- a heating system (44, 46, 48, 52);
- an image-taking system, comprising an infrared camera (36) and a converter generating a block of data by recording a unitary image;
- an image-processing system (42) comprising means for storing the block of data corresponding to the recording of the unitary image;
- means for storing a standard image constituted by a set of standard signals, each standard signal being paired with the true location of any object point on the board (26);
- means for comparing, for any one true location, a measurement signal with the standard signal;
- and means (44) for displaying the true location concerned and the result of the comparison operation;
characterised in that:
- the board holder (20) is provided with an arrangement allowing the two-dimensional geographical identification (CX, CZ, 34) of said true location,
- the block of data of the image-taking system comprises, for each image point in the image field of the camera, the corresponding image location and the measurement signal representing the temperature at the associated object point on the board (26) covered by the elementary object field of the camera (36),
- a device (38) for plotting the field of the camera (36) associated with said board holder (20), said geographical identification arrangement (CX, CY, CZ, 34) being suitable for identifying the positioning of the field of the camera relative to the board,
- the image-processing system (42) also comprising:
means associated with said geographical identification arrangement (CX, CY, CZ, 34), for determining the true location of the object point associated with a given image location of the block of data corresponding to the given unitary image recording and to pair each measurement signal to the corresponding true location.

17. Equipment according to Claim 16, characterised in that said holder (20) for a board (26) also comprises a fixed frame (22) carrying said device (38) for plotting the field of the camera and provided with means (24) for guiding the board (26).

18. Equipment according to Claim 17, characterised in that said geographical identification arrangement (CX, CY, CZ, 34) is of a three-dimensional type and comprises a pilot station (34) for identifying the positioning of the field of the camera (36) and controlling means (MX, MY, MZ) for activating said guiding means (24) and said plotting device (38) to allow relative displacements between the board (26) and the field of the camera (36).

19. Equipment according to one of Claims 17 and 18, characterised in that the guiding means (24) for the board comprise a set of guide rails (28, 30, 32) and a trolley for carrying the board (26) to allow the displacement of the board in two perpendicular directions (X, Z).

20. Equipment according to Claim 19, characterised in that the device (38) for plotting the field of the camera is capable of displacement in a direction (Y) normal to the plane of displacement (X, Z) of said trolley.

21. Equipment according to one of Claims 18 to 20, characterised in that a pilot station (34) controls the image-taking and image-processing systems (36, 42) and manages a process for recording and processing unitary images sequentially starting with a virtual cutting up of the board into elementary exploration zones (ZEi) corresponding to the object field of the camera covered by a unitary image.

22. Equipment according to Claim 21, characterised in that said pilot station (34) generates the unitary image recording orders as a function of a predefined programme for geographically exploring the board.

23. Equipment according to one of Claims 21 and 22, characterised in that said pilot station (34) transmits to said means for pairing each measurement signal to the corresponding true location, which are present in said image-processing system (42), data concerning the instantaneous positioning of the field of the camera relative to the board used when each unitary image is recorded.

24. Equipment according to one of claims 21 to 23, characterised in that the pilot station (34) commands a relative displacement between the board (26) and the field of the camera (36) after each unitary image is recorded.

25. Equipment according to Claims 16 and 21 taken in combination, characterised in that the pilot station (34) starts said image-taking and image-processing process on receipt of a start signal issued by the control station (54).
